Europäisches Patentamt

**European Patent Office**

Office européen des brevets

(11) Publication number: **0 198 697**
**A2**

# EUROPEAN PATENT APPLICATION

(21) Application number: **86302751.2**

(22) Date of filing: **14.04.86**

(51) Int. Cl.⁴: **H 01 R 23/70**

(30) Priority: **16.04.85 GB 8509718**

(43) Date of publication of application: **22.10.86**
**Bulletin 86/43**

(84) Designated Contracting States: **DE FR GB**

(71) Applicant: **PLESSEY OVERSEAS LIMITED, Vicarage Lane, Ilford Essex IGI 4AQ (GB)**

(72) Inventor: **Duncan, William Chambers Wilson, 5 Georges Avenue, Bugbrooke Northampton (GB)**
Inventor: **Osborne, Colin Sidney, 12 Dobson Close, Gt. Houghton Northampton (GB)**

(74) Representative: **Johnson, Reginald George, The Plessey Company plc§Intellectual Property Department§Vicarage Lane, Ilford, Essex IG1 4AQ (GB)**

(54) **Improvements in or relating to an adaptor for a printed circuit board connector.**

(57) An adaptor is provided for a printed circuit board connector (2) of the kind having a grid array of contacts (4). The adaptor (10) has a plurality of electrical conductors (20, 22, 24) a terminal end (20', 22', 24') of each of which is adapted for attachment to a respective contact (4) of the grid array of contacts of the connector (2). The other ends of the electrical conductors (20, 22, 24) of the adaptor (10) are arranged to define an in-line array of contacts, so that the adaptor (10) is able to serve to convert a grid array contact arrangement into an in-line contact arrangement.

# IMPROVEMENTS IN OR RELATING TO AN ADAPTOR FOR A PRINTED CIRCUIT BOARD CONNECTOR

The present invention relates to an adaptor for a printed circuit board connector.

A traditional type of printed circuit board (PCB) comprises a laminate having components on one side and etched or deposited circuitry on the other side. Component leads are fed through holes in the laminate and soldered to conductor pads associated with the components.

With the ever-increasing need to increase circuitry and packaging densities a technology known as surface mounting has been developed. Surface-mount technology involves producing 'lead-less' components which are mounted directly to the circuit-carrying side of the PCB. This in turn has given rise to the need for printed circuit board connectors to be surface-mounted, that is to say the connectors do not require feed-through holes but have their contacts soldered directly to the lead circuit pads on the PCB.

One of the objects of the present invention is to provide a space saving adaptor for use with a printed circuit board connector, the connector being of the kind having contacts arranged in equispaced rows so as to define a grid array of contacts.

- 2 -

According to the present invention there is provided an adaptor for a printed circuit board connector of the kind having a grid array of contacts, the adaptor comprising a plurality of electrical conductors a terminal end of each of which is adapted for attachment to a respective contact of the grid array of contacts of the connector, the other ends of the electrical conductors of the adaptor being arranged to define an in-line array of contacts, the adaptor thereby serving to convert a grid array contact arrangement into an in-line contact arrangement.

In a preferred embodiment of the present invention the adaptor is provided with a location member for holding the electrical conductors in equispaced alignment during the assembly of the connector and the adaptor to the PCB. The location member may be formed integrally with the electrical conductors or alternatively it may comprise a separate jig.

In one embodiment of the present invention there is provided an adaptor for a printed circuit board connector of the kind having contacts arranged in a plurality of equispaced rows, the adaptor comprising a plurality of electrical conductors having terminals arranged in adjacent equispaced groups, at least one electrical conductor in each group having a cranked terminal such that the ends of the terminals in each group are arranged to define a line which when assembled to the connector contacts is orthogonal to the rows of contacts, whereby one terminal of each group is provided for each row of connector contacts and whereby the electrical conductors extend orthogonally to the rows of connector contacts to define an in-line array of contacts on the adaptor.

In one specific embodiment of the present invention an adaptor is provided for a printed circuit board connector of the kind having contacts arranged in three rows equispaced by approximately 0.1 inch to define a 0.1 inch grid array, the adaptor comprising a strip of conductors formed from sheet metal material at a spacing of approximately 0.03 inch, which prior to assembly of the connector and the adaptor to the printed circuit board are held at one end in equispaced alignment, by a location member and which at the other end are formed, for example by press piercing, to define terminal ends arranged in similar equispaced groups of three, on a 0.1 inch grid to match the connector contacts, and wherein two conductors of each group of three have cranked terminals such that the terminal ends in each group define a line which when assembled to the connector contacts is orthogonal to the rows of contact, whereby one terminal of each group is provided for each row of connector contacts and whereby

0198697

- 4 -

the electrical conductors extend orthogonally to the rows of connector contacts to define an in-line array of contacts on the adaptor.

In a preferred embodiment of the present invention the location member is a carrier strip formed integrally with the electrical conductors at said one end.

In another embodiment of the present invention the electrical conductors comprise strips of metal foil or wires embedded in an insulating laminate material, the material being provided with a grid array of holes, each hole being in alignment with a terminal end of a respective conductor thereby providing a grid array of holes for matching and assembly to the corresponding grid array of contacts on the connector.

The present invention also provides an electrical assembly comprising a printed circuit board, a printed circuit board connector of the kind having contacts arranged in equispaced rows to define a grid array and an adaptor of the kinds defined above for converting the grid array contact arrangement into an in-line array of contacts.

The present invention will now be described further, by way of examples, with reference to the accompanying drawings in which:-

Figures 1a and 1b illustrate the conventional way of connecting the contacts of a connector to circuitry on a PCB,

Figure 2a illustrates an arrangement of circuit pads and tracks associated with the assembly of Figure 2b,

Figure 2b illustrates an adaptor in accordance with one embodiment of the present invention assembled with the connector of Figure 1a on the PCB,

Figure 3 illustrates part of the construction of an adaptor according to an embodiment of the present invention;

Figure 4 illustrates the adaptor of Figure 3 mounted between the connector and the surface of the PCB;

Figure 5 illustrates part of the construction of an adaptor in accordance with a further embodiment of the present invention;

Figure 6 illustrates the adaptor of Figure 5 mounted between the connector and the surface of the PCB;

Figure 7 illustrates part of the construction of an adaptor in accordance with a further embodiment of the present invention and;

Figure 8 is a side view of the adaptor of Figure 7 prior to assembly with the connector and the PCB.

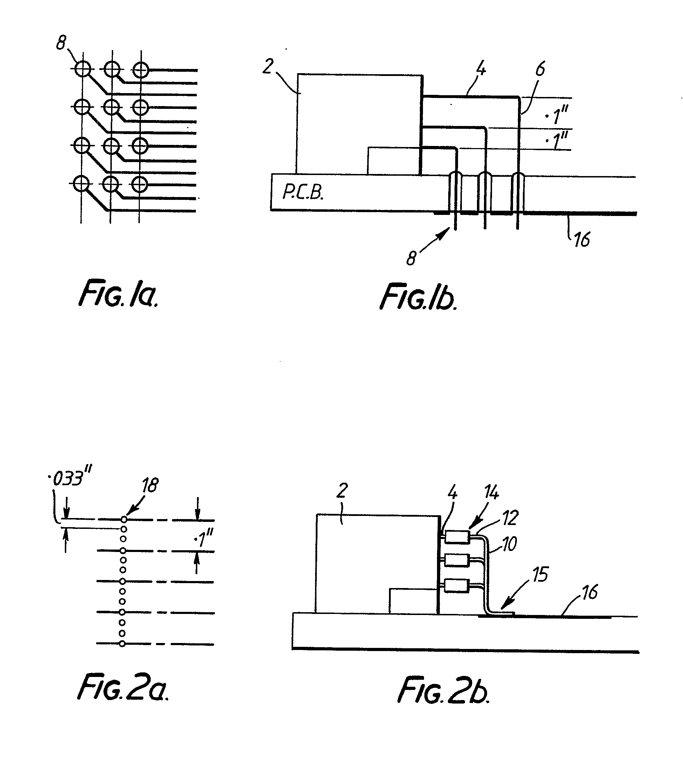

Referring to Figures 1a and 1b a printed circuit board connector 2 is mounted on and near one edge of a major surface of a printed circuit board (PCB). The connector 2 is of a conventional kind having contacts 4 arranged in three rows equispaced by 0.1 inch to define a 0.1 inch grid array. The contacts 4 are attached to leads 6 each of which passes through a respective hole 8 formed in the PCB, the ends of the leads 6 being soldered to conductor pads 18 on the other side of the PCB.

The hole and track pattern in and on the PCB and associated with the assembly of Figure 1b is shown in Figure 1a. The pattern matches that of the grid array of contacts on the connector, that is to say the pattern consists of three rows of holes extending transversely across the surface of the PCB, the rows being equispaced by 0.1 inch.

Referring to Figure 2b an adaptor 10 is provided in accordance with one embodiment of the present invention. The adaptor 10 has electrical conductors 12 the terminal end of each of which is attached to a respective contact 4 of the connector 2 by a soldered or press-fitted connection 14. The other end 15 of each of the electrical conductors 12 is adapted to be soldered or sprung to a respective surface conductor 16 on the surface of the PCB. The surface conductor 16 may take the form of a track and the contact with the electrical conductor 12 may be at a conductor pad 18. As illustrated in Figure 2a the conductor pads 18 are spaced apart by 0.033 inch and are arranged as an in-line array extending transversely across the surface of the PCB. In this way the adaptor 10 serves to convert a grid array contact arrangement into an in-line contact arrangement thereby conserving space on the surface of the PCB.

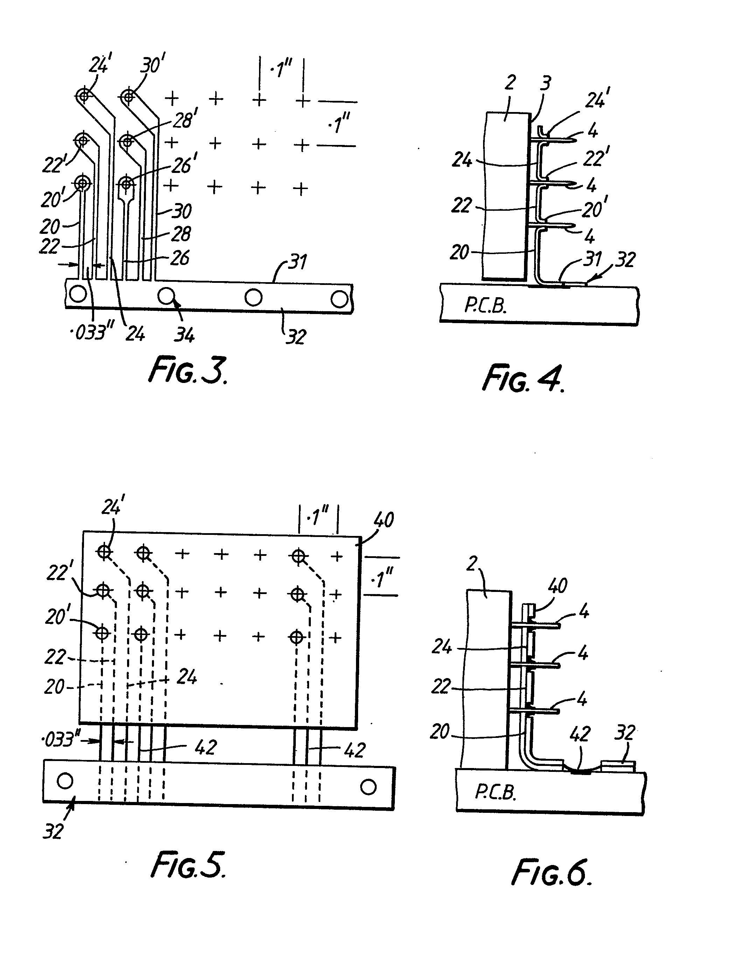

Referring to the embodiment of Figure 3 the electrical conductors are formed by press tooling from a metallic material, typically a copper alloy strip. The electrical conductors are arranged in equispaced groups of three, the conductors being spaced apart by 0.033 inches. For illustration purposes just two of the groups of conductors are shown in Figure 3, each group consisting of the three conductors 20,22,24 and 26,28,30 respectively. Each conductor has a terminal end which is press pierced and drawn as a hole, the terminal ends of each group being designated in Figure 3 by numerals $20^1$, $22^1$, $24^1$ and $26^1$, $28^1$, $30^1$ respectively. A pair of conductors 22, 24 and 28, 30 in each of the groups are cranked so that the terminal ends in each group are spaced by 0.1 inch and together define a single line.

The other ends of the electrical conductors are integral with a location member, in the form of a carrier strip 32, which is connected to the conductors along a common line 31. The line 31 serves as a fracture line during the final process stage of assembly with the connector and the PCB. The carrier strip 32 is provided along its length with a series of equispaced holes 34 for precise alignment of the carrier strip 32 to the PCB to enable accurate location of the conductors during the assembly process.

The assembly of the conductors to the contacts 4 of the connector 2 is illustrated in Figure 4. Each contact 4 in Figure 4 is one contact in a respective row of contacts extending across a side surface 3 of the connector 2. The three rows of contacts on the connector 2 are equispaced by 0.1 inch to define a 0.1 inch grid array of contacts.

Before assembly of the adaptor to the connector 2 and to the PCB the carrier strip 32 and the end portions of the conductors adjacent the fracture line 31 are turned through 90 degrees. The adaptor is then placed in the position shown in Figure 4 having the terminal ends of the conductors pressed over the contacts 4 and the carrier strip 32 located temporarily in position on the surface of the PCB. The end portions of the conductors adjacent the fracture line 31 are soldered to the surface of the PCB, the carrier strip 32 released and bent in a direction away from the PCB to initiate fracture along the line 31 thereby completing the assembly process. The portions of

- 9 -

the conductors soldered to the surface of the PCB define an in-line array of contacts like that shown in Figure 2a.

An alternative embodiment of the adaptor is illustrated in Figures 5 and 6 in which the electrical conductors of Figures 3 and 4 are replaced by strips of metal foil or wires.  Identical reference numerals have been used in Figures 5 and 6 as to those used for identical or similar features in Figures 3 and 4.

Referring to Figures 5 and 6 the terminal ends of the conductors are retained in accurate alignment with one another by being embedded in an insulating laminate material 40.  The material 40 is provided with a grid array of holes, each hole being in alignment with a terminal end of a respective conductor thereby providing a grid array of holes for matching and assembly to the corresponding grid array of contacts on the connector 2. Portions 42 of the conductors adjacent the carrier strip 32 are exposed by removal of sections of the insulation material 40.  As can be seen from Figure 6 the assembly process of the adaptor of Figure 5 to the connector 2 to the surface of the PCB is similar to that described with reference to Figures 3 and 4, the exposed areas of conductors at portions 42 being soldered to the PCB before the carrier strip 32 is removed.

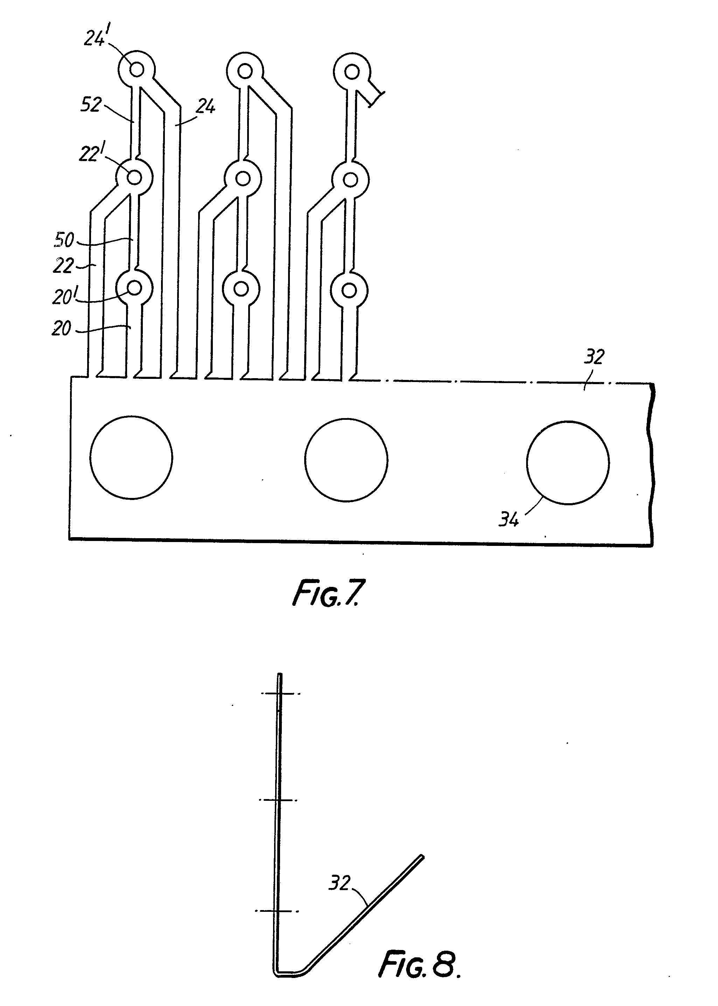

Another embodiment of the adaptor is illustrated in Figure 7, the adaptor being pressed or etched from a blank metallic strip to leave tie strips 50, 52 between the pairs of terminal ends $20^1$, $22^1$ and $22^1$, $24^1$ respectively. Furthermore, notches are provided between the tie strips and the terminal ends, and between the end portions of the conductors and the carrier strip 32 facilitating removal of the tie strips and the carrier strip 32 after the assembly process. The presence of the tie strips between the terminal ends provides additional location means for maintaining the conductors in alignment during their assembly to the connector and the PCB.

It will be appreciated that whereas in the above embodiments the adaptors have been described as suitable for connecting between a grid array of contacts of a connector and the PCB, an adaptor may also or alternatively be used in other embodiments of the present invention for connecting a grid array of contacts of a component to the PCB should the need be required.

-11-

CLAIMS:

1. An adaptor for a printed circuit board connector of the kind having a grid array of contacts characterised in that the adaptor (10) comprises a plurality of electrical conductors (12, 20, 22, 24) a terminal end (20', 22', 24') of each of which is adapted for attachment to a respective contact (4) of the grid array of contacts (4) of the connector (2), the other ends of the electrical conductors of the adaptor (10) being arranged to define an in-line array of contacts, the adaptor (10) thereby serving to convert a grid array contact arrangement into an in-line contact arrangement.

2. An adaptor as claimed in claim 1 characterised in that the adaptor is provided with a location member (32) for holding the electrical conductors (20, 22, 24) in equispaced alignment during the assembly of the connector (2) and the adaptor to the printed circuit board (PCB).

3. An adaptor as claimed in claim 2 characterised in that the location member (32) is formed integrally with the electrical conductors (20, 22, 24).

4. An adaptor as claimed in claim 3 characterised in that the location member (32) is a carrier strip formed integrally with the electrical conductors (20, 22, 24) at their said other ends.

5. An adaptor as claimed in any one of claims 1 to 4 characterised in that the electrical conductors (20, 22, 24) comprise strips of metal foil or wires embedded in an insulating laminate material (40), the material (40) being provided with a grid array of holes, each hole being in alignment with a terminal end (20', 22', 24') of a respective conductor (20, 22, 24) thereby providing a grid array of holes for matching and assembly to the corresponding grid array of contacts (4) on the connector (2).

6. An adaptor as claimed in any one of claims 1 to 5 characterised in that the plurality of electrical conductors (20, 22, 24) have their terminals (20', 22', 24') arranged in adjacent equispaced groups, at least one electrical conductor (20, 22, 24) in each group having a cranked terminal such that the ends of the terminals in each group are arranged to define a line which when assembled to the connector contacts (4) is substantially orthogonal to the rows of contacts (4), whereby one

-13-

terminal (20', 22', 24') of each group is provided for each row of connector contacts (4) and whereby the electrical conductors (20, 22, 24) extend substantially orthogonally to the rows of connector contacts (4) to define an in-line array of contacts on the adaptor (10).

7. An adaptor for a printed circuit board connector of the kind having contacts arranged in three rows equispaced by approximately 0.1 inch to define a 0.1 inch grid array, characterised in that the adaptor (10) comprises a strip of conductors (20, 22, 24) formed from sheet metal material at a spacing of approximately 0.3 inch, which prior to assembly of the connector (2) and the adaptor (10) to the printed circuit board (PCB) are held at one end in equispaced alignment by a location member (32), and which at the other end are formed to define terminal ends (20', 22', 24') in similar equispaced groups of three, on a 0.1 inch grid to match the connector contacts (4), and wherein two conductors (22, 24) of each group of three have cranked terminals such that the terminal ends (20', 22', 24') in each group define a line which when assembled to the connector contacts (4) is substantially orthogonal to the rows of contacts (4), whereby one terminal (20', 22', 24') of each group is provided for each row of connector contacts (4) and whereby the electrical conductors (20, 22, 24) extend substantially orthogonally to the rows of connector contacts (4) to define an in-line array of contacts on the adaptor (10).

8.   An assembly comprising a printed circuit board, a printed circuit board connector of the king having contacts arranged in equispaced rows to define a grid array and an adaptor, characterised in that the adaptor (10) is as claimed in any one of claims 1 to 7 for converting the grid array contact arrangement into an in-line array of contacts.

Fig. 1a.

Fig. 1b.

Fig. 2a.

Fig. 2b.

FIG. 3.

FIG. 4.

FIG. 5.

FIG. 6.

Fig.7.

Fig. 8.